# EUROPEAN PATENT SPECIFICATION

(11) **EP 2 187 225 B1**
(45) Date of publication and mention of the grant of the patent: **10.07.2013**
(21) Application number: 09466012.3
(22) Date of filing: 07.08.2009
(51) Int. Cl.: G01R 31/02

(54) **Apparatus and method of detecting faults in medium voltage covered conductors**
Vorrichtung und Verfahren zum Erfassen von Fehlern in ummantelten Mittelspannungsstromleitern
Appareil et procédé pour détecter des défauts dans des conducteurs moyenne tension gainés

(30) Priority: 22.10.2008 CZ 20080647
(43) Date of publication of application: 19.05.2010
(73) Proprietor: Vysoka Skola Banska-Technicka Univerzita, 708 33 Ostrava - Poruba (CZ)
(72) Inventor: Misák, Stanislav, 779 00 Olomouc (CZ); Válek, Pavel, 76 701 Kromeriz (CZ); Foldyna, Jiri, 739 11 Janovice (CZ)

(56) References cited:
- WO-A2-03/052434
- US-A1- 2006 139 031
- US-B1- 6 329 924
- US-B2- 7 424 400

## Description

### Field of invention

This invention is related to the distribution of electrical energy and provides a solution to the detection of faults in medium voltage electrical distribution circuits consisting of covered conductors, which can result from ruptured covered conductors.

### Background

It is a well-known fact that covered conductors are utilized in medium voltage electrical systems in remote areas and in locations where there is an greater probability of contact with other covered conductors for the purpose of decreasing the eventual occurrence of faults. The current method of detecting a fault in a medium voltage electrical system is based on detecting short-circuits which occur between the phase-conducting wire and ground when the phase conducting line is ruptured. However, in the event of covered conductor breakage, grounding does not take place and therefore, currently utilized systems and methods of detection are useless.
Furthermore, it is common knowledge that the breakage of a covered conductor in a three-phase electrical distribution circuit can only be detected in the event that it has occurred in the near surrounding of the switch station, due to the fact that the fault will only appear as an increase in asymmetry.
Devices and methods utilized in detecting covered conductor breakage in a three-phase circuit are unknown at present.

WO 03/052434 discloses the detection of faults in the shielding of conductors. A test signal is applied to the shield and the resultant electric field is detected.

### Summary of the invention

As specified in the invention, the above mentioned drawbacks are resolved with the apparatus and the applied method for detecting breakdowns in medium voltage covered conductors. The basic principle of the method according to claim 1 depends on scanning the electrical stray field in the surrounding of the covered conductor, whereupon impulse elements are separated from the signals of electrical stray field and are further frequency-filtered. Then the effective value of impulse elements which are relevant to a specified preset time period and selected time intervals are calculated; at the same time, at least one value is registered and the subsequent and/or simultaneous ones are compared with the efficient values which are consistent to various time periods of scanning. A fault in medium voltage covered conductor is detected by comparing common values. Alternatively, it is of prime importance that prior to frequency filtration of impulse components the signal is digitalized and that the impulse component frequency filtration takes place by eliminating signals of higher frequency than 20 kHz.
The fundamental principle of the apparatus according to claim 4 is that it contains an electrical stray field scanner which is interconnected in the unit to the frequency filter for the purpose of obtaining impulse components. The frequency filter is further connected to a computing unit whose output is connected to an evaluation unit. Alternatively, the assembled unit for obtaining impulse components and apparatus for the separation of impulse components are purposely coupled. According to other options the voltage divider is capacitive; the electrical stray field scanner is toroidal and encircles the insulation of the covered conductor; there is an A/D converter between the unit for reading the impulse components and frequency filter, or between the device for segregating impulse components and frequency filter. Other alternatives can also include computing and evaluation units combined as a computing and evaluation unit, or the evaluating unit can be connected to the device for remote access, eventually, the remote access device can be integrated with the evaluation unit.

The main advantage of this invention is reliable detection of faults in a three-phase current distribution system which is caused by breaks in any of the covered conductors in the event that the breakage takes place at a remote distance from the switch station. According to this invention in placing this apparatus on electrical line posts at certain distances, it is not only possible to identify affected faulty outputs, but also specify the general location of the fault which leads to the shortening of the breakdown period to a minimum.

### Brief description of the drawings

The schematic diagram of the apparatus for detecting faults in medium voltage covered conductors equipped with one-phase coil insulation can be seen in the first illustration and the second illustration examples.

### Examples of the Invention Concept

Example 1 medium voltage covered conductor faults 2 contains an electrical stray field sensing device which is in this case an toroidal sensor 3, which encircles the insulation of the covered conductor 2. The metal toroidal sensor 3 is connected to the control centre 10 in sequence through the unit 55 for impulse component reading purposes, A/D converter 6, frequency filter 7, computing unit 8 and evaluating unit 9. Unit 55 for reading impulse components is comprised of a voltage divider 4 and device 54 for dividing impulse components. The metal toroidal sensor 3 is directly connected into the input 41 of the capacity divider 4. The primary part of the capacity divider 4 is equipped with a primary, sensing capacity device 42 with a 60 pF value, and the secondary part is equipped with a second capacitor 43. The first output of the first, sensing, capacitor 42 is comprised of the 4 capacity divider input 41, while the second output is comprised of a capacity divider 4 output 44 which is connected with the input 61 of the A/D converter 6. The second output of the first sensing capacitor 42 is further connected with the first output of the second capacitor 43. The second output of the second capacitor 43 is made up of a capacity divider 4 grounding output 45. The grounding output 45 of the capacity divider 4 is connected to the grounding input 62 of the A/D converter, both of which are mutually grounded. The value of the second capacitor 43 amounts to 280 pF for each meter of line length between the output 44 of the capacity divider 4 and A/D converter 6 input 61. Furthermore, there is a resistor 5, which together with the second capacitor 43 comprises a device for dividing impulse components, between the capacity divider 4 output 44 and its grounding output 45, interlinked in such a way with the capacity divider 4. The A/D converter 6 is equipped with a high-speed measuring card and is connected with its output 63 to the frequency filter 7 input 71. The frequency filter 7 output 72 is further connected with the input 81 of the computing unit 8, whose output 82 is additionally connected with the input 91 of the evaluation unit 9. The device 93 for remote access which is capable of communication with the dispatch centre, located in the switch station 10, is integrated with the evaluation unit 9.
The method of detecting faults according to the invention can be illustrated in the following manner. The metal toroidal sensor 3 reads the behaviour of the electrical stray field in the surrounding of the covered conductor 2. The capacity divider 4 simultaneously with the resistor 5, which function as a band rejection filter for basic components of electrical field signals and transmits only impulse components of this type of signal, divides the impulse components from the obtained signals. The impulse signal components are digitalized by the A/D converter 6, and frequencies below 10 kHz are intercepted with the frequency filter 7. The signal is further conveyed to the computing unit 8 and evaluation unit 9. The computing unit 8 evaluates the effective values of the electric field impulse components according to pre-programmed time intervals and stores them in the database. The evaluation unit 9 compares the newly detected effective values of the electric field impulse components with the values entered in the database which correspond with the previous time intervals. It evaluates the effective value of the electric field impulse components in the time intervals and stores them into the database. On the bases of variations in the effective values of the electric field impulse components, which correspond to different time intervals, the evaluation unit 9 determines if a fault has occurred. If a fault is detected, a fault signal is sent to the dispatch centre 10 with the remote access device 93.

### Example 2

According to this example the apparatus varies from the one described in example 1, so that the voltage divider 4 isn't coupled with the impulse component dividing unit 54, therefore the output of the voltage divider 45 is connected with the input 56 of the impulse component dividing unit 54. Furthermore, the apparatus in example 2 differs from the apparatus in example 1 so that the computing unit 8 and evaluating unit 9 are coupled together creating the computing and evaluating unit 89 whose output 92 is connected with the dispatch centre 10 with an electrical line 96. The apparatus in example 2 works in the same manner as the apparatus in example_1, with the difference that the frequency filter 7 eliminates frequencies below 15 kHz.

### Industrial Utilization

The invention can be utilized in medium voltage electrical energy distribution stations which contain covered conductors.

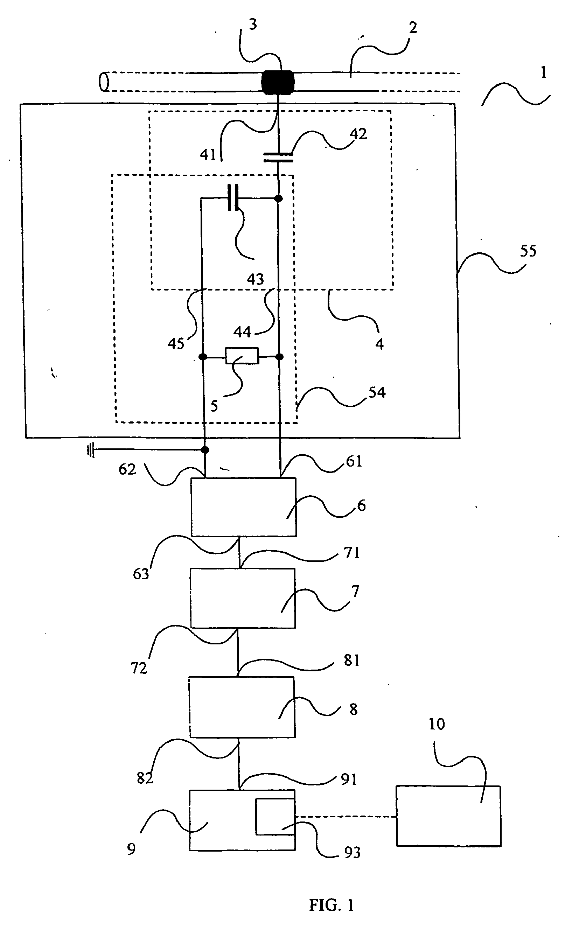

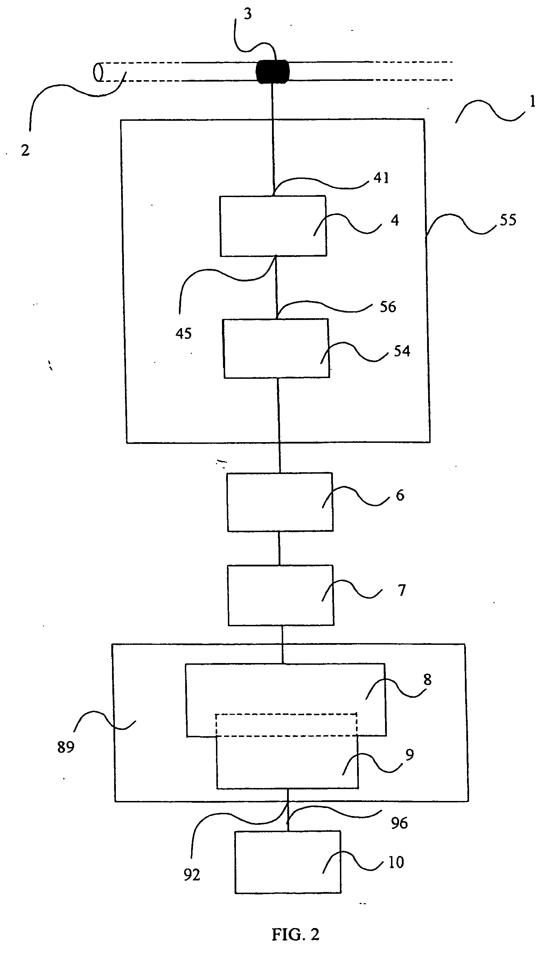

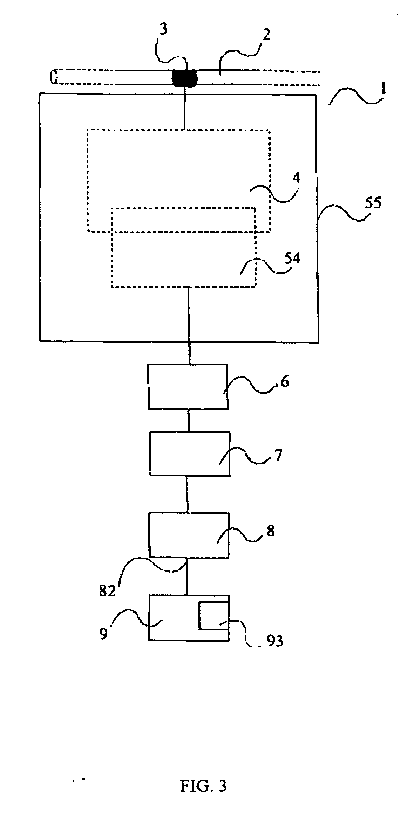

## Claims

1. A method of fault detection of a medium-voltage covered conductor, where an electric stray field signal is sensed around the covered conductor **characterized by** the following steps :
separation of the impulse components from the sensed signal;
further filtering the impulse components in the frequency domain;
calculation of effective values of said filtered impulse components corresponding to predetermined time intervals,
recording at least one such effective value;
comparing said at least one such effective value with further such effective values corresponding to different time intervals;
on the basis of this comparison detecting a fault in the medium-voltage covered conductor.

2. The method according to Claim 1 is **characterized by** the fact that the signal is digitised before the frequency filtration of the impulse component.

3. The method according to Claim 1 or 2 is **characterized by** the fact that the frequency filtration of the impulse component is carried out so that only components of the signal in the high-frequency area are transmitted.

4. A device adapted for the implementation of the fault detection method of a medium-voltage covered conductor according to Claim 1 or 2 or 3 is **characterized by** the fact that it contains a sensor (3) of the electric stray field, which is connected through a unit (55) serving to obtain the impulse component for the frequency filter (7), which is further connected to a computing unit (8), whose output (82) is connected with an evaluation unit (9).

5. The device according to Claim 4 is **characterized by** the fact that the sensor (3) of the electric stray field is toroidal and surrounds the insulation of the medium-voltage covered conductor (2).

## Patentansprüche

1. Verfahren zur Fehlererkennung eines ummantelten Mittelspannungsstromleiters, in welchem ein elektrisches Streufeldsignal um den ummantelten Stromleiter herum abgetastet wird, **gekennzeichnet durch** die folgenden Schritte:
Trennen der Impulskomponenten vom abgetasteten Signal;
Weiterfiltem der Impulskomponenten in der Frequenzdomäne;
Berechnen der Effektivwerte dieser gefilterten Impulskomponenten entsprechend vorbestimmten Zeitintervallen,
Aufzeichnen zumindest eines solchen Effektivwerts;
Vergleichen des zumindest einen solchen Effektivwerts mit weiteren solchen Effektivwerten, die verschiedenen Zeitintervallen entsprechen;
auf der Grundlage dieses Vergleichs Erkennen eines Fehlers in dem ummantelten Mittelspannungsstromleiter.

2. Verfahren nach Anspruch 1 ist durch die Tatsache gekennzeichnet, dass das Signal vor der Frequenzfilterung der Impulskomponente digitalisiert wird.

3. Verfahren nach Anspruch 1 oder 2 ist durch die Tatsache gekennzeichnet, dass die Frequenzfilterung der Impulskomponente so ausgeführt wird, dass nur Komponenten des Signals im Hochfrequenzbereich übertragen werden.

4. Vorrichtung, die eingerichtet ist, um das Verfahren zur Fehlererkennung eines ummantelten Mittelspannungsleiters nach Anspruch 1 oder 2 oder 3 zu implementieren, **dadurch gekennzeichnet, dass** sie einen Sensor (3) des elektrischen Streufelds enthält, der über eine Einheit (55) verbunden ist, die dazu dient, die Impulskomponente für den Frequenzfilter (7) zu erhalten, welcher weiters mit einer Berechnungseinheit (8) verbunden ist, deren Ausgang (82) mit einer Bewertungseinheit (9) verbunden ist.

5. Vorrichtung nach Anspruch 4, **dadurch gekennzeichnet, dass** der Sensor (3) des elektrischen Streufelds ringförmig ist und die Isolierung des ummantelten Mittelspannungsstromleiters (2) umgibt.

## Revendications

1. Procédé pour la détection des défaillances d'un conducteur moyenne tension recouvert, dans lequel un signal d'un champ de dispersion électrique est détecté autour dudit conducteur recouvert, **caractérisé par** les étapes suivantes:
la séparation des composants des impulsions dudit signal détecté;
le filtrage desdits composants des impulsions dans le domaine de fréquences;
le calcul des valeurs effectives de ceux composants filtrés des impulsions qui correspondent à des intervalles de temps prédéterminés;
l'enregistrement d'au moins une de ces valeurs effectives;
la comparaison de ladite au moins une valeur effective avec d'autres valeurs effectives qui correspondent à d'autres intervalles de temps;
la détection d'une défaillance dans ledit conducteur moyenne tension recouvert sur la base de ladite comparaison.

2. Procédé selon la revendication 1, **caractérisé en ce que** ledit signal est numérisé avant le filtrage desdits composants des impulsions.

3. Procédé selon la revendication 1 ou 2, **caractérisé en ce que** ledit filtrage des composants des impulsions est réalisé d'une manière que seulement les composants à haute fréquence dudit signal sont transmises.

4. Dispositif pour la réalisation d'un procédé pour la détection des défaillances d'un conducteur moyenne tension recouvert selon la revendication 1 ou 2 ou 3, **caractérisé en ce que** ledit dispositif comprend un capteur (3) pour ledit champ de diversion électrique, qui est relié à une unité (55) pour obtenir le composant des impulsions pour un filtre de fréquences (7) qui, à son tour, est relié à une unité de calcul (8), la sortie (82) de laquelle est reliée à une unité d'évaluation (9).

5. Dispositif selon la revendication 4, **caractérisé en ce que** ledit capteur (3) pour le champ de diversion électrique est toroïdal et entoure l'isolation dudit conducteur moyenne tension recouvert (2).
